# EUROPEAN PATENT APPLICATION

(11) **EP 1 710 832 A2**
(43) Date of publication of application: **11.10.2006**
(21) Application number: 06075745.7
(22) Date of filing: 30.03.2006
(51) Int. Cl.: H01L 21/56, H01L 23/485

(54) **Electronic assembly with a noflow underfill**

(30) Priority: 05.04.2005 US 99074
(71) Applicant: Delphi Technologies, Inc., Troy, MI 48007 (US)
(72) Inventor: Delheimer, Charles I., Noblesville, IN 46060 (US); Chaudhuri, Arun K., Carmel, IN 46032 (US); Stepniak, Frank, Noblesville, IN 46060 (US)
(74) Representative: Denton, Michael John

(57) **Abstract**

An electronic assembly (400) includes an integrated circuit (IC) die (306), a substrate (302) and a no-flow underfill (310) applied between the IC die (306) and the substrate (302). The IC die (306) includes a plurality of conductive contacts formed on a surface of the die (306). The substrate (302) includes a plurality of conductive traces (304) formed on a surface of the substrate (302) and electrically connected to at least one of the conductive contacts by electrical interconnects (320). The interconnects (320) each include a polymer core having an electrically conductive solderable outer surface. The polymer core has a coefficient of thermal expansion (CTE) that approximately matches the CTE of the no-flow underfill (310).

## Description

### Technical Field

The present invention is generally directed to an electronic assembly and, more specifically, to an electronic assembly with a no-flow underfill.

### Background of the Invention

Various electronic assemblies that have included an integrated circuit (IC) die, e.g., a flip-chip, electrically coupled to conductive traces (pads) of a substrate have utilized an underfill to better secure the flip-chip to the substrate. In general, most of these underfills have been applied, through a capillary action, after the circuit interconnection has been achieved. Typically, the underfills have been an epoxy resin with added fillers, which more closely match the coefficient of thermal expansion (CTE) of the underfill to the solder alloy of the flip-chip solder bumps. The flip-chip solder bumps, after a solder reflow process, provide electrical interconnection between the flip-chip and the substrate to which the flip-chip is being assembled. Matching the CTE of the underfill and the solder bumps has been desirable to ensure long-term reliability of the interconnection, when the electronic assembly has been subjected to temperature extremes, such as those seen in the automotive environment.

In general, the capillary underfill process has required a number of steps, which include a clean, a pre-bake, an underfill dispense and a post-cure step, all of which increase both cycle time and manufacturing costs. In an effort to reduce the number of processing steps, some manufacturers of electronic assemblies have utilized no-flow underfills that have been applied prior to soldering the flip-chip in place. The advantage of no-flow underfills is that they eliminate the need for clean and bake process steps, which have been required for assemblies that have utilized capillary underfills. Unfortunately, no-flow underfills are unfilled, as any fillers are prone to becoming trapped in a bondline between a solder bump of the flip-chip and the substrate. Thus, electronic assemblies that have implemented no-flow underfills have typically exhibited a relatively poor CTE match between the solder bumps and the no-flow underfill. As such, the electronic assemblies that have used no-flow underfills have generally been less reliable than those utilizing capillary underfills.

What is needed is a manufacturing technique for an electronic assembly that allows for the utilization of no-flow underfills in applications where the electronic assembly is subject to temperature extremes, such as those experienced in the automotive environment.

### Summary of the Invention

According to one embodiment of the present invention, an electronic assembly includes an integrated circuit (IC) die, a substrate and a no-flow underfill applied between the IC die and the substrate. The IC die includes a plurality of conductive contacts formed on a surface of the die. The substrate includes a plurality of conductive traces formed on a surface of the substrate and electrically connected to at least one of the conductive contacts by electrical interconnects. The interconnects each include a polymer core having an electrically conductive solderable outer surface. The polymer core has a coefficient of thermal expansion (CTE) that approximately matches the CTE of the no-flow underfill.

According to various aspects of the present invention, the no-flow underfill may be an epoxy resin system, which may be a thermally, UV or microwave cured epoxy resin that does not include a filler. According to one aspect of the present invention, the IC die is a flip-chip. According to another aspect of the present invention, the polymer core is spherical. According to a different embodiment, an outer surface of the polymer core is plated with copper, which is further plated with leaded or lead-free solder.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
Fig. 1 is a cross-sectional view of an exemplary electronic assembly, according to the prior art;
Fig. 2 is a partial cross-sectional view of an electronic assembly, constructed according to the present invention; and
Fig. 2A is an expanded cross-sectional view of a portion of the electronic assembly of Fig. 2.

### Description of the Preferred Embodiments

According to one aspect of the present invention, an electronic assembly is constructed that implements electrical interconnects that each include a polymer core sphere having an electrically conductive solderable outer surface, e.g., a Micropearl™ SOL, hereafter referred to as an electrical interconnect. The outer surface may be, for example, plated with a first layer of copper and a second layer of solder. The utilization of an electrical interconnect allows a designer to approximately match a coefficient of thermal expansion (CTE) of the polymer core to a desired no-flow underfill material. In this manner, the no-flow underfill, usually an unfilled epoxy resin system, is enhanced towards reliability performances and, thus, avoids the problems associated with the implementation of fillers in no-flow underfills. As such, an electronic assembly with a no-flow underfill may be manufactured with fewer process steps than required for an electronic assembly that uses a capillary underfill. Further, process steps are reduced and the end result is an electronic assembly that meets or exceeds automotive reliability requirements.

In general, the electrical interconnects are applied to the IC die, e.g., a flip-chip, and held in place with a solder. The substrate also has a solder pre-applied to conductive pads of the substrate, where circuit interconnects are required. A no-flow underfill (e.g., Part No. Fluxfill 2200, manufactured and made commercially available by Loctite) is then applied to the substrate at the site where the flip-chip is to be placed and the flip-chip is assembled to the substrate. The electrical interconnects are completed by reflowing the solder in a typical reflow process. The solder reflow process forms interconnects that have a polymer core made conductive as described above and the underfill is cured during the same heat cycle that reflows the solder, eliminating the need for cleaning and also reducing cycle time in the manufacturing of the electronic assembly. As stated above, the polymer core of the electrical interconnects is selected to closely match the CTE of the selected no-flow underfill material. Micropearl™ SOL interconnects are manufactured and made commercially available by Sekisui Chemicals.

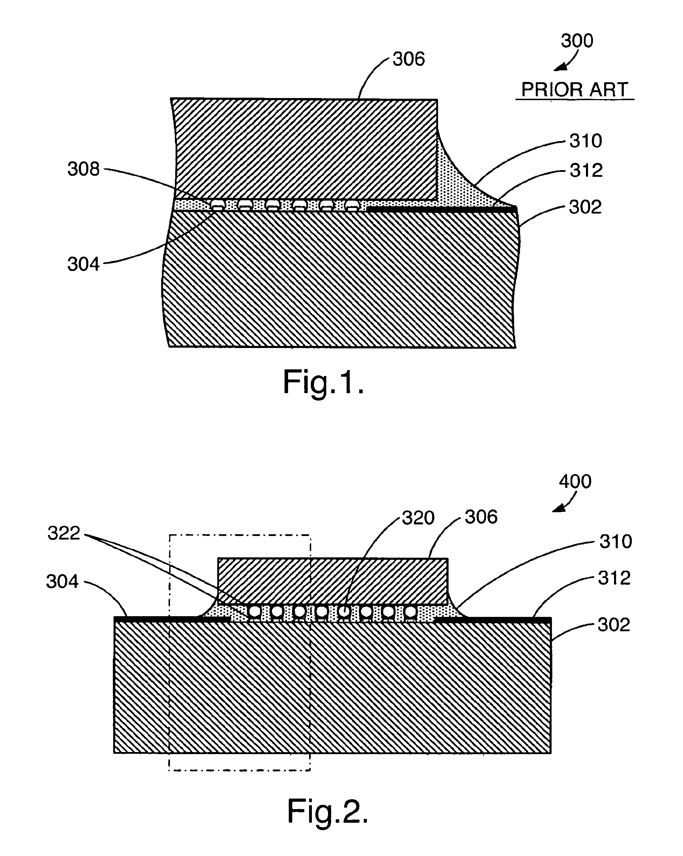

With reference to Fig. 1, a relevant portion of an electronic assembly 300, according to the prior art, is depicted. As is shown in the partial cross-section of Fig. 1, a flip-chip 306 is electrically coupled to electrical contacts 304, formed on substrate 302, with solder bumps 308. As is depicted, a solder mask 312 is positioned outside of and slightly underneath the IC die 306 and a capillary underfill material 310 is positioned between the flip-chip 306 and the substrate 302.

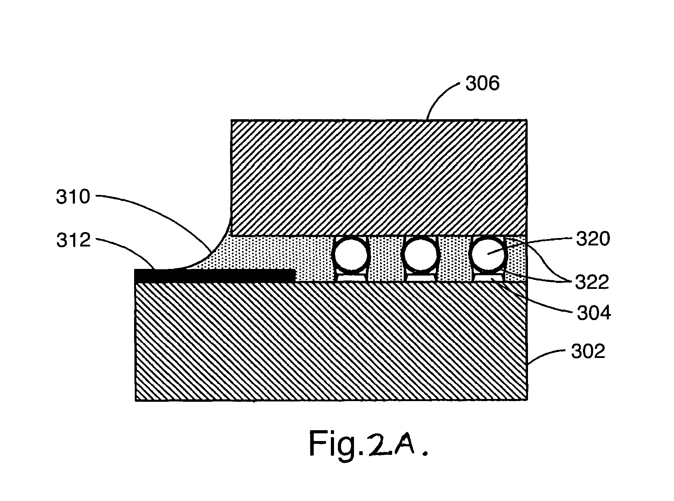

According to the present invention, a relevant portion of an electronic assembly 400, as is shown in Figs. 2-2A, is constructed using electrical interconnects 320, which include a polymer core sphere having an electrically conductive solderable outer surface, e.g., the solderable outer surface of the contacts 320 may be made of copper with an overcoating of solder. During a solder reflow process, solder 322 is utilized to electrically connect the die 306 to electrical contacts (traces) 304 formed on a surface of the substrate 302. A no-flow underfill 310 may be positioned indiscriminatingly in the area between the die and substrates prior to the solder reflow process, which reflows the solder 322 to electrically interconnect the die 306 to the traces 304. The no-flow underfill may be an epoxy resin, e.g., Part No. Fluxfill 2200, manufactured and made commercially available by Loctite.

Accordingly, electronic assemblies have been described herein that implement electrical interconnects having polymer cores, made conductive as discussed above, to electrically connect an IC die to a substrate. Electronic assemblies so constructed are lower in cost, as the number of processing steps are reduced, and are capable of providing a desired reliability in relatively harsh environments, such as those experienced by motor vehicles.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. An electronic assembly (400), comprising:
an integrated circuit (IC) die (306) including a plurality of conductive contacts formed on a surface of the die (306);
a substrate (302) including a plurality of conductive traces (304) formed on a surface of the substrate (302) and electrically connected to at least one of the conductive contacts by electrical interconnects (320), wherein the interconnects (320) each include a polymer core having an electrically conductive solderable outer surface; and
a no-flow underfill (310) applied between the IC die (306) and the substrate (302), wherein the polymer core has a coefficient of thermal expansion (CTE) that approximately matches a CTE of the no-flow underfill (310).

2. The assembly (400) of claim 1, wherein the no-flow underfill (310) is an epoxy resin system.

3. The assembly (400) of claim 2, wherein the epoxy resin system is a thermally, UV or microwave cured epoxy resin.

4. The assembly (400) of claim 2, wherein the epoxy resin system does not include a filler for matching the CTE of the interconnects (320).

5. The assembly (400) of claim 1, wherein the IC die (306) is a flip-chip.

6. The assembly (400) of claim 1, wherein the polymer core is spherical.

7. The assembly (400) of claim 1, wherein an outer surface of the polymer core is plated with copper that is plated with leaded or lead-free solder.

8. An electronic assembly (400), comprising:
an integrated circuit (IC) die (306) including a plurality of conductive contacts formed on a surface of the die (306);
a substrate (302) including a plurality of conductive traces (304) formed on a surface of the substrate (302) and electrically connected to at least one of the conductive contacts by electrical interconnects (320), wherein the interconnects (320) each include a polymer core having an electrically conductive solderable outer surface; and
a no-flow underfill (310) applied between the IC die (306) and the substrate (302), wherein the polymer core has a coefficient of thermal expansion (CTE) that approximately matches a CTE of the no-flow underfill (310), and wherein the polymer core is spherical.

9. The assembly (400) of claim 8, wherein the no-flow underfill (310) is an epoxy resin system.

10. The assembly (400) of claim 9, wherein the epoxy resin system is a thermally, UV or microwave cured epoxy resin.

11. The assembly (400) of claim 9, wherein the epoxy resin system does not include a filler for matching the CTE of the interconnects (320).

12. The assembly (400) of claim 8, wherein the IC die (306) is a flip-chip.

13. The assembly (400) of claim 9, wherein the outer surface is plated with copper that is plated with leaded or lead-free solder.

14. An electronic assembly (400), comprising:
an integrated circuit (IC) die (306) including a plurality of conductive contacts formed on a surface of the die (306);
a substrate (302) including a plurality of conductive traces (304) formed on a surface of the substrate (302) and electrically connected to at least one of the conductive contacts by electrical interconnects (320), wherein the interconnects (320) each include a polymer core having an electrically conductive solderable outer surface; and
a no-flow underfill (310) applied between the IC die (306) and the substrate (302), wherein the polymer core has a coefficient of thermal expansion (CTE) that approximately matches a CTE of the no-flow underfill (310), and wherein the outer surface is plated with copper, which is further plated with leaded or lead-free solder.

15. The assembly (400) of claim 14, wherein the no-flow underfill (310) is an epoxy resin system.

16. The assembly (400) of claim 15, wherein the epoxy resin system is a thermally, UV or microwave cured epoxy resin.

17. The assembly (400) of claim 15, wherein the epoxy resin system does not include a filler for matching the CTE of the interconnects (320).

18. The assembly (400) of claim 14, wherein the IC die (306) is a flip-chip.

19. The assembly (400) of claim 14, wherein the polymer core is spherical.
